# FASCICULE DE BREVET EUROPEEN

(11) **EP 3 817 054 B1**
(45) Date de publication et mention de la délivrance du brevet: **13.12.2023**
(21) Numéro de dépôt: 20202899.9
(22) Date de dépôt: 20.10.2020
(51) Int. Cl.: H01L 33/00, H01L 33/38, H01L 33/44, H01L 27/15, H01L 31/18, H01L 31/0224, H01L 27/146, H01L 33/32, H01L 33/40, H01L 31/0304

(54) **PROCÉDÉ DE RÉALISATION D'AU MOINS UNE DIODE PHOTO-ÉMETTRICE OU PHOTO-RÉCEPTRICE**
VERFAHREN ZUR HERSTELLUNG MINDESTENS EINER LICHTEMITTIERENDEN ODER LICHTEMPFANGENDEN DIODE
METHOD FOR MANUFACTURING AT LEAST ONE LIGHT-EMITTING OR LIGHT-RECEIVING DIODE

(30) Priorité: 28.10.2019 FR 1912074
(43) Date de publication de la demande: 05.05.2021
(73) Titulaire: Commissariat à l'énergie atomique et aux énergies alternatives, 75015 Paris (FR)
(72) Inventeur: DUPRE, Ludovic, 38054 GRENOBLE CEDEX 09 (FR); FOURNIER, Hélène, 38054 GRENOBLE CEDEX 09 (FR); HENRY, Franck, 38054 GRENOBLE CEDEX 09 (FR)
(74) Mandataire: Brevalex

(56) Documents cités:
- EP-A1- 2 960 940
- EP-A1- 3 070 752
- WO-A1-2019/079381
- WO-A1-2019/141948
- FR-A1- 3 042 913
- US-A1- 2018 233 535
- US-A1- 2018 301 479

## Description

### DOMAINE TECHNIQUE

L'invention concerne le domaine des diodes photo-émettrices ou diodes électroluminescentes (appelées DELs ou LEDs, ou encore micro-LEDs ou µLEDs lorsque leurs dimensions sont de quelques micromètres ou quelques dizaines de micromètres) ainsi que celui des diodes photo-réceptrices ou photodiodes. L'invention s'applique notamment au domaine des dispositifs d'éclairage par LEDs, des dispositifs électroniques émissifs lumineux comprenant des matrices de LEDs tels que des écrans, des projecteurs, des phares de voitures ou des murs d'images, ainsi qu'au domaine des dispositifs électroniques ou microélectroniques photorécepteurs comportant des matrices de photodiodes, tels que des capteurs d'images. L'invention concerne notamment la fabrication de matrices de LEDs ou µLEDs à partir d'empilement de semi-conducteurs GaN/InGaN pour la réalisation d'écrans de visualisation ou d'éclairage matriciel.

### ÉTAT DE LA TECHNIQUE ANTÉRIEURE

La réalisation de diodes, par exemple lors de la réalisation d'une matrice de photodiodes ou de LEDs formant une matrice de pixels, se base généralement sur la mise en oeuvre de procédés microélectroniques standards utilisés communément en technologie dite planaire et au cours desquels chaque élément des diodes est réalisé par une étape de dépôt, puis une étape de lithographie suivie d'une étape de gravure. Avec ce type de procédé, la réalisation de chaque motif d'un matériau des diodes nécessite la mise en oeuvre d'au moins trois étapes distinctes. De plus, chaque motif réalisé doit être aligné avec ceux précédemment réalisés. Enfin, la définition de chaque motif doit prendre en compte les performances des équipements concernés tant en termes de dimensions atteignables que de performances d'alignement par rapport au motif précédent.

De plus, pour obtenir des performances suffisantes avec les technologies standards de la micro-électronique, une planarisation des éléments réalisés est nécessaire afin de maîtriser les étapes de lithographie mises en oeuvre sur ces éléments car la résolution atteignable avec une étape de lithographie est directement liée à la topographie sur laquelle cette lithographie est mise en oeuvre, les objectifs optiques à très grandes ouvertures utilisés dans les dispositifs d'insolation lithographiques ayant des profondeurs de champ qui s'amenuisent avec l'augmentation de la résolution.

Le document FR 3 042 913 A1 décrit un procédé de fabrication auto-alignée de matrices de LEDs ou µLEDs. Dans ce procédé, les pixels sont réalisés de manière auto-alignée, c'est-à-dire à l'aide d'un unique niveau de lithographie permettant de séparer physiquement les différentes LEDs tout en créant les structures en mesa des LEDs. Les tranchées réalisées permettent également de prendre le contact électrique sur l'une des parties dopées N ou P des LEDs uniquement par un contact avec les flancs latéraux de cette partie. Ces tranchées d'isolation optique entre pixels sont gravées jusqu'au substrat de croissance du semi-conducteur formant la jonction P-N des LEDs puis remplies par un matériau formant une électrode métallique réfléchissante, ce qui permet de bien isoler optiquement les pixels entre eux car la lumière émise par un pixel est alors extraite directement sous ce pixel et n'est pas guidée dans le semi-conducteur vers un pixel voisin (phénomène de diaphonie, ou « crosstalk » en anglais). Ainsi, cette structure de matrice de pixels assure un contraste optique optimal et une bonne définition optique des pixels. D'autres procédés de fabrication de matrices de LEDs sont connus des documents WO 2019/079381 A1, EP 2 960 940 A1, WO 2019/141948 A1, US 2018/0301479 A1, EP 3 070 752 A1 et US 2018/0233535 A1.

Cependant, du point de vue électrique, il est préférable que le contact électrique entre le semi-conducteur de la partie dopée N ou P se trouvant sur le substrat et les électrodes assurant l'isolation optique ne se fasse pas au niveau des flancs latéraux de cette partie mais par exemple au niveau d'une surface parallèle au substrat, en raison des meilleures propriétés électriques des plans cristallins parallèles à la surface de croissance. Cela permet l'obtention d'une meilleure réponse électrique, c'est-à-dire un courant électrique plus important pour une même tension de fonctionnement, et donc, dans le cas des diodes photo-émettrices, une plus grande quantité de lumière émise pour une même puissance électrique injectée. Par contre, réaliser le contact électrique au niveau d'une surface parallèle au substrat implique de ne pas graver le semi-conducteur jusqu'au substrat pour en conserver une partie au fond des tranchées, ce qui dégrade l'isolation optique entre les pixels, c'est-à-dire augmente la diaphonie entre les pixels. Cela est décrit dans le document "Processing and characterization of high resolution GaN/InGaN LED arrays at 10 micron pitch for micro display applications" de L. Dupré et al., Proc. of SPIE vol. 10104, Gallium Nitride Materials and Devices XII, pp. 1010422-1 à 8, 2017.

Un compromis doit donc être réalisé entre l'isolation optique des pixels et la réponse électrique obtenues.

Dans le document FR 2 992 465 A1, un dispositif à LEDs est réalisé à partir d'un empilement de couches semi-conductrices pré-structurées sous formes d'îlots indépendants, chaque îlot servant à la réalisation d'une LED du dispositif. La réalisation de l'anode de chaque LED comporte la gravure d'une ouverture d'une couche diélectrique déposée au préalable sur le semi-conducteur de type p. Pour assurer une bonne définition géométrique de cette électrode, il est nécessaire de réaliser cette ouverture par une gravure sèche assistée par plasma. Or, l'InGaN utilisé pour la réalisation de ce dispositif est un semi-conducteur à grand gap qui est altéré par ce type de gravure, ce qui conduit à une mauvaise interface électrique et donc à une dégradation irréversible des propriétés électriques des LEDs. D'autre part, le procédé présenté dans ce document implique la mise en oeuvre d'étapes de photolithographie nécessitant un alignement précis contraignant par rapport à un procédé auto-aligné qui ne présente aucune limitation d'alignement et donc de dimension minimale des structures fabriquées.

### EXPOSÉ DE L'INVENTION

Un but de la présente invention est de proposer une diode dont la structure permet de concilier une bonne isolation optique entre pixels et une bonne réponse électrique des pixels, et qui puisse être réalisée de manière auto-alignée et sans dégradation de ses propriétés électriques.

Pour cela, la présente invention propose, conformément à la revendication indépendante 1 en annexe, un procédé de réalisation d'au moins une diode photo-émettrice ou photo-réceptrice, comportant au moins :
- réalisation, sur un premier substrat, d'au moins un empilement comprenant des première et deuxième couches de semi-conducteur dopées selon des types de conductivité opposés, et au moins une troisième couche de semi-conducteur intrinsèque, ou semi-conducteur non intentionnellement dopé, disposée entre les première et deuxième couches, la première couche étant disposée entre le premier substrat et la troisième couche ;
- gravure de tranchées traversant les deuxième et troisième couches et une première partie de la première couche, entourant des portions restantes des deuxième et troisième couches et de la première partie de la première couche, et telles que le fond des tranchées soit formé par une deuxième partie de la première couche disposée entre la première partie de la première couche et le premier substrat ;
- réalisation, dans les tranchées, d'au moins un espaceur diélectrique recouvrant des parois latérales desdites portions restantes ;
- gravure prolongeant les tranchées à travers des portions de la deuxième partie de la première couche non recouvertes par l'espaceur diélectrique, jusqu'au premier substrat ;
- gravure latérale d'une partie de l'espaceur diélectrique, révélant des surfaces de contact, par exemple horizontales, de la deuxième partie de la première couche ;
- réalisation, dans les tranchées, d'au moins une première électrode en contact avec les surfaces de contact de la deuxième partie de la première couche et avec des flancs latéraux de la deuxième partie de la première couche.

Des modes avantageux de réalisation de la présente invention sont l'objet des revendications dépendantes en annexe.

Du fait que la première électrode se prolonge jusqu'au premier substrat, l'isolation optique de la diode est très efficace. Lorsque cette diode forme un pixel comprenant des pixels voisins, une bonne isolation optique entre pixels est donc obtenue, ce qui permet d'éviter les interactions lumineuses entre les diodes voisines.

De plus, du fait que la première électrode est reliée électriquement au semi-conducteur de la portion restante de la première couche par l'intermédiaire des parois latérales de la deuxième partie de la première couche et par l'intermédiaire des surfaces de contact formées par la gravure latérale de l'espaceur diélectrique, une bonne réponse électrique de la diode est également obtenue.

Cette diode fait appel à un espaceur diélectrique, c'est-à-dire un élément d'isolation électrique, recouvrant les flancs latéraux d'une partie des éléments formant la jonction p-n de la diode et permettant d'isoler électriquement et de passiver ces flancs latéraux, notamment vis-à-vis de la première électrode, et également d'isoler électriquement les portions de semi-conducteur dopées de la jonction p-n l'une vis-à-vis de l'autre. Cet espaceur diélectrique permet également d'assurer l'isolation électrique entre la première électrode et la deuxième électrode en occupant un minimum de place dans la diode. Cette localisation de l'espaceur diélectrique sur les flancs latéraux de la jonction p-n de la diode permet d'améliorer le rapport entre la surface active de la diode (surface occupée par la jonction p-n) et la surface totale occupée par la diode, et donc de réduire son encombrement.

De plus, cette forte intégration de l'espaceur diélectrique a également pour avantage de minimiser les densités de courant obtenues dans les électrodes de la diode, et donc de réduire l'échauffement par effet Joule engendré dans la diode via une baisse globale de la résistance thermique de la diode.

La structure de cette diode permet de réduire son coût de fabrication ainsi que sa consommation d'énergie. Dans le domaine de l'éclairage, une telle diode permet d'améliorer l'injection électrique obtenue et donc d'augmenter son rendement énergétique. Dans le domaine des dispositifs imageurs, une telle diode permet de réaliser des dispositifs à haute résolution par la réduction de la taille des pixels qui devient limitée uniquement par les moyens de mise en forme utilisés.

Le terme « couche » est utilisé, ici et dans tout le reste du document, pour désigner une seule couche ou un empilement de plusieurs couches.

La jonction p-n formée et l'espaceur diélectrique forment une structure mesa. L'expression « structure mesa » désigne le fait que la diode est réalisée sous la forme d'un empilement de portions de semi-conducteur dopées, une zone de jonction à base de semi-conducteur intrinsèque étant présente entre ces portions de semi-conducteur dopées, et que cet empilement est ici gravé sur toute sa hauteur sous forme d'un îlot appelé mesa.

Les parois de fond (i.e. les fonds) des tranchées peuvent être horizontales.

L'espaceur diélectrique étant déposé sur les flancs latéraux de la structure gravée dans l'empilement de couches, cet espaceur diélectrique peut être réalisé par un procédé auto-aligné permettant d'isoler les électrodes de la diode sans faire appel à un masque spécialement adapté à la réalisation de cet espaceur diélectrique, par exemple via un dépôt conforme du matériau de l'espaceur diélectrique puis une gravure, par exemple anisotrope, des portions de ce matériau diélectrique qui ne recouvrent pas les flancs latéraux de la structure.

La première couche de semi-conducteur peut être dopée n et la deuxième couche de semi-conducteur peut être dopée p, la première électrode pouvant dans ce cas former une cathode de la diode.

La diode réalisée peut comporter, du côté opposé à celui où se trouve le premier substrat, une surface continue sensiblement plane. Cette surface continue sensiblement plane permet d'hybrider facilement, par exemple sans faire appel à des inserts tels que des microbilles de connexion, la diode à un autre élément tel qu'un substrat permettant de réaliser différentes configurations de connexion de la diode et pouvant comporter également une face plane au niveau de laquelle se trouvent des matériaux analogues à ceux de la diode, par exemple par collage direct métal contre métal (pour les électrodes) et diélectrique contre diélectrique (notamment pour l'espaceur diélectrique). Cette surface continue sensiblement plane est également bien adaptée pour la réalisation d'une structure d'interconnexions directement sur les électrodes, évitant ainsi bon nombre de difficultés liées à la topologie résiduelle des structures des diodes de l'art antérieur.

L'expression « sensiblement plane » est ici utilisée pour désigner le fait que la surface ainsi formée peut présenter des variations de hauteur, ou d'épaisseur, comprises entre environ 0 et 150 nm. Ces légères variations de hauteur ou d'épaisseur peuvent avoir pour origine la mise en oeuvre d'une planarisation mécano-chimique (CMP) mise en oeuvre en présence des matériaux des électrodes et des matériaux diélectriques, les vitesses de gravure de ces différents matériaux étant différentes les unes des autres. Ces légères variations de hauteur ou d'épaisseur peuvent avoir pour avantage de garantir une excellente isolation entre les électrodes de la diode et/ou vis-à-vis d'électrodes de diodes adjacentes lorsque des creux sont formés au niveau des faces supérieures des électrodes.

La première couche de semi-conducteur peut comporter un empilement d'au moins deux semi-conducteurs dopés selon des niveaux de conductivité différents. Par exemple, lorsque la première couche de semi-conducteur est dopée n, elle peut comporter un empilement d'un premier semi-conducteur dopé n+ disposé sur le premier substrat et d'un deuxième semi-conducteur dopé n- disposé sur le premier semi-conducteur.

La diode peut être une photodiode ou une LED. Lorsque la diode est une LED, elle peut comporter plusieurs troisièmes couches de semi-conducteur intrinsèque formant une zone active émissive à au moins un puits quantique disposée entre les semi-conducteurs des première et deuxième couches.

La gravure latérale mise en oeuvre ici correspond à une gravure réduisant l'épaisseur d'au moins une partie de l'espaceur diélectrique.

L'espaceur diélectrique peut avoir, avant la mise en oeuvre de la gravure latérale, une épaisseur initiale supérieure ou égale à 1 µm.

La partie de l'espaceur diélectrique supprimée lors de la gravure latérale peut avoir une épaisseur comprise entre 10 nm et une épaisseur initiale de l'espaceur moins 10 nm, afin que l'épaisseur restante d'espaceur soit suffisante pour assurer une bonne isolation électrique.

Les surfaces de contact de la deuxième partie de la première couche peuvent être perpendiculaires aux parois latérales desdites portions restantes.

Le procédé peut comporter en outre, entre la réalisation de l'empilement et la gravure des tranchées à travers les deuxième et troisième couches et la première partie de la première couche, la réalisation d'au moins un masque de gravure disposé sur l'empilement et ayant un motif correspondant à celui des tranchées, et l'espaceur diélectrique peut être réalisé en recouvrant également des parois latérales du masque de gravure.

Dans un premier mode de réalisation, la gravure latérale d'une partie de l'espaceur diélectrique correspond à une gravure isotrope.

Le masque de gravure peut comporter au moins un matériau qui est au moins partiellement gravé lors de la gravure latérale d'une partie de l'espaceur diélectrique.

L'espaceur diélectrique peut comporter du SiO₂.

Dans un deuxième mode de réalisation, la réalisation de l'espaceur diélectrique peut comporter :
- dépôt d'au moins une couche d'un premier matériau diélectrique recouvrant les parois latérales desdites portions restantes ;
- dépôt d'au moins une couche d'un deuxième matériau diélectrique recouvrant la couche du premier matériau diélectrique, le deuxième matériau diélectrique étant choisi tel qu'il ait une vitesse de gravure supérieure à celle du premier matériau diélectrique lors de la gravure latérale d'une partie de l'espaceur diélectrique qui correspond à une gravure anisotrope ;
et dans lequel la gravure prolongeant les tranchées et la gravure latérale d'une partie de l'espaceur diélectrique peuvent être mises en oeuvre simultanément au cours d'une même étape de gravure.

Le procédé peut être tel que :
- l'empilement comporte en outre au moins une couche électriquement conductrice telle que la deuxième couche soit disposée entre la troisième couche et la couche électriquement conductrice (cette couche électriquement conductrice peut être disposée entre la deuxième couche et un masque de gravure lorsqu'un masque de gravure est utilisé) ;
- les tranchées gravées traversent la couche électriquement conductrice et entourent au moins une portion restante de la couche électriquement conductrice formant une première partie d'une deuxième électrode ;
- l'espaceur diélectrique recouvre des parois latérales de la première partie de la deuxième électrode ;
et le procédé peut comporter en outre, après la gravure latérale d'une partie de l'espaceur diélectrique, une étape de réalisation d'une deuxième partie de la deuxième électrode.

Dans ce cas, la réalisation de la première électrode et de la deuxième partie de la deuxième électrode peut comporter au moins :
- réalisation d'au moins une ouverture à travers l'empilement et débouchant sur la première partie de la deuxième électrode ;
- dépôt d'au moins un matériau électriquement conducteur dans l'ouverture et dans les tranchées ;
- planarisation du matériau électriquement conducteur.

Dans ce cas, la réalisation des électrodes correspond à la mise en oeuvre d'un procédé de type « damascène » dans lequel un ou plusieurs matériaux électriquement conducteurs sont formés par au moins un dépôt pleine plaque, c'est-à-dire un dépôt du matériau électriquement conducteur sur l'ensemble de la structure réalisée, les électrodes étant obtenues ensuite via une planarisation de ce ou ces matériaux électriquement conducteurs. La réalisation de la première électrode ne nécessite donc pas une étape d'alignement spécifique ou de masquage particulier. L'emplacement de la première électrode peut correspondre à un espace formé par les tranchées entre des diodes voisines.

Le procédé peut comporter en outre, après la réalisation de la première électrode et de la deuxième partie de la deuxième électrode, un report de la diode photo-émettrice ou photo-réceptrice sur un substrat d'interconnexions tel que les première et deuxième électrodes de la diode photo-émettrice ou photo-réceptrice soient reliées électriquement au substrat d'interconnexions, puis une étape de retrait du premier substrat.

La couche électriquement conductrice peut être optiquement réflectrice, c'est-à-dire peut présenter un coefficient de réflexion en amplitude (rapport de l'amplitude de la lumière réfléchie sur l'amplitude de la lumière incidente) d'au moins 80 %. Dans ce cas, la deuxième électrode, qui est disposée du côté opposé à celui par lequel la lumière est destinée à entrer ou sortir de la diode, peut être optiquement réflectrice. Ainsi, la lumière peut entrer ou sortir de la diode sans avoir à traverser une électrode transparente, par exemple à base d'un oxyde transparent conducteur tel que l'ITO, qui engendre des pertes optiques de la lumière émise ou reçue.

L'invention concerne également, conformément à la revendication 14 en annexe, un procédé de réalisation d'un dispositif électronique, comportant la mise en oeuvre d'un procédé tel que décrit ci-dessus, dans lequel les étapes mises en oeuvre forment plusieurs diodes photo-émettrices et/ou plusieurs diodes photo-réceptrices dans lesquelles les premières électrodes desdites diodes sont reliées électriquement entre elles.

Selon une configuration particulière, les premières électrodes des diodes du dispositif peuvent former une cathode commune à ces diodes.

Les diodes peuvent faire partie d'une matrice de diodes de structures similaires formant une matrice de pixels du dispositif électronique.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

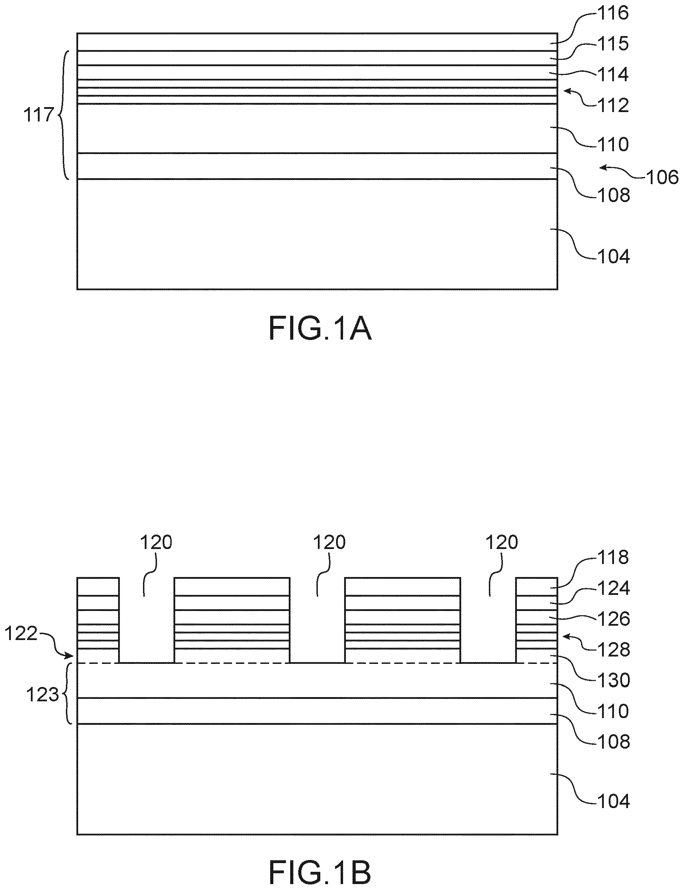

- les figures 1A à 1J représentent les étapes d'un procédé, selon la présente invention, de réalisation d'un dispositif électronique, incluant un procédé, également selon la présente invention, de réalisation d'une diode photo-émissive ou photo-réceptrice, selon un premier mode de réalisation de la présente invention;

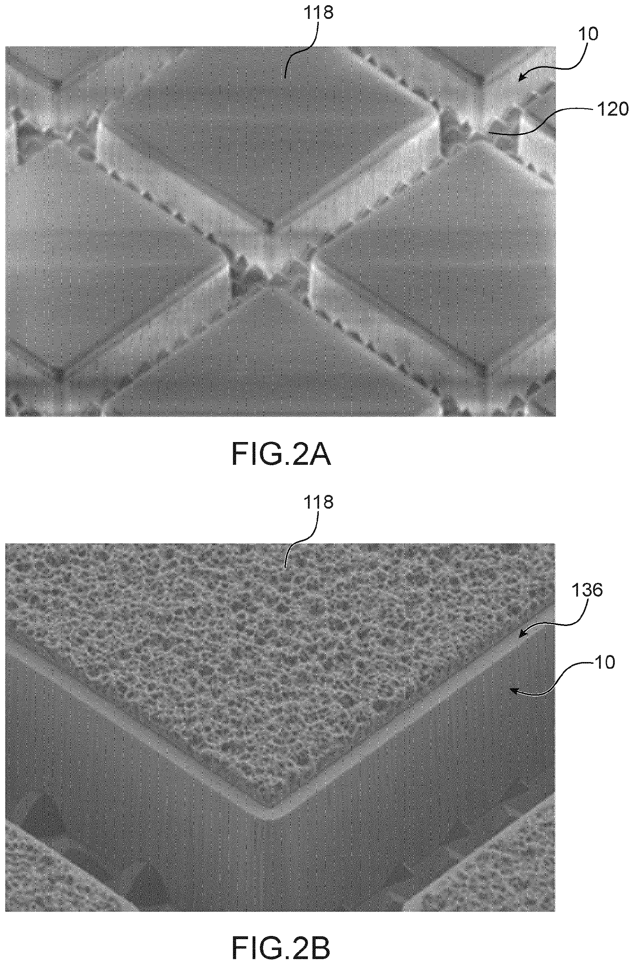

- les figures 2A et 2B représentent des photos d'une structure obtenue lors de la mise en oeuvre d'une gravure latérale isotrope d'un masque de gravure similaire à celle mise en oeuvre au cours du procédé, selon la présente invention, de réalisation d'une diode photo-émissive ou photo-réceptrice, selon le premier mode de réalisation ;

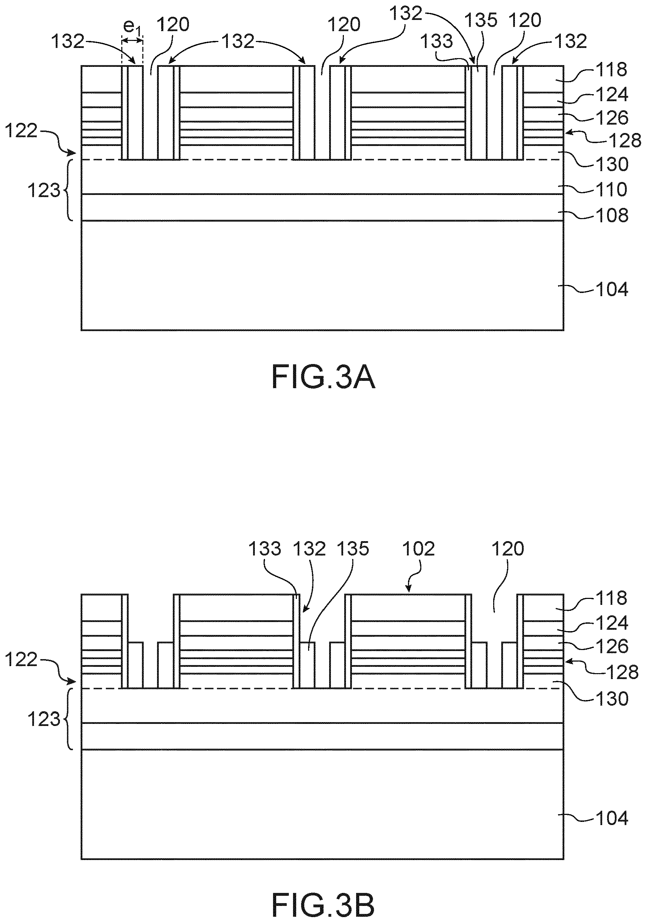

- les figures 3A et 3B représentent une partie des étapes d'un procédé , selon la présente invention, de réalisation d'un dispositif électronique, incluant un procédé, également selon la présente invention, de réalisation d'une diode photo-émissive ou photo-réceptrice, selon un deuxième mode de réalisation de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation de la présente invention) doivent être comprises comme n'étant pas exclusives les unes des autres et peuvent se combiner entre elles, tant que ces combinaisons demeurent dans le cadre de l'étendue de la présente invention telle que définie par les revendications en annexe.

### EXPOSÉ DÉTAILLÉ DE MODES DE RÉALISATION PARTICULIERS

Les figures 1A à 1J représentent les étapes d'un procédé de réalisation d'un dispositif électronique 100 selon un premier mode de réalisation. Dans le premier mode de réalisation décrit ici, le dispositif 100 comporte plusieurs diodes 102 correspondant ici à des diodes photo-émissives ou électroluminescentes.

Comme représenté sur la figure 1A, le dispositif 100 est réalisé à partir d'un premier substrat 104 comprenant par exemple du saphir, du silicium, un semi-conducteur similaire à celui utilisé pour former la partie active des diodes 102, ou tout autre matériau permettant au premier substrat 104 de former un substrat de croissance pour le dépôt d'un empilement semi-conducteur à partir duquel les diodes 102 seront réalisées. Le premier substrat 104 sert de support pour le dépôt ou la croissance de couches destinées à la réalisation des diodes 102 du dispositif 100.

Une première couche 106 de semi-conducteur dopé selon un premier type de conductivité, par exemple de type n, est réalisée sur le premier substrat 104.

Selon un exemple de réalisation particulier, cette première couche 106 correspond à un empilement de plusieurs couches distinctes de semi-conducteur, par exemple une couche 108 de semi-conducteur dopée n+ avec une concentration de donneurs par exemple comprise entre environ 5.10¹⁷ et 5.10²⁰ donneurs/cm³ sur laquelle est disposée une autre couche 110 de semi-conducteur dopée n- avec une concentration de donneurs par exemple comprise entre environ 10¹⁷ et 5.10¹⁹ donneurs/cm³. Par exemple, la couche 108 peut comporter du GaN et la couche 110 peut comporter de l'InGaN. L'épaisseur de la couche 108 est par exemple supérieure à environ 100 nm, par exemple égale à environ 3 µm, et celle de la couche 110 est par exemple comprise entre environ 5 nm et 500 nm. L'épaisseur totale de la première couche 106, c'est-à-dire la somme des épaisseurs des couches 108 et 110 dans cet exemple de réalisation particulier, est par exemple comprise entre environ 20 nm et 10 µm, et de préférence comprise entre environ 2 µm et 4 µm. La couche 108 forme ici une couche tampon disposée entre la couche 110 et le premier substrat 104 et sert notamment à filtrer les défauts de croissance afin que ces défauts ne se retrouvent pas dans la couche 110 qui sert à former les jonctions p-n des diodes 102.

En variante, les couches 108 et 110 peuvent être dopées avec un même niveau de dopage.

Selon une autre variante, la couche 106 peut correspondre à une seule couche de semi-conducteur. Cette unique couche de semi-conducteur est par exemple dopée n et peut avoir une concentration de donneurs par exemple comprise entre environ 10¹⁷ et 5.10²⁰ donneurs/cm³. A titre d'exemple, cette couche peut comporter du GaN et son épaisseur est par exemple comprise entre environ 20 nm et 10 µm, et avantageusement comprise entre environ 2 µm et 4 µm.

Selon une autre variante, la couche 106 peut correspondre à un empilement de plusieurs couches distinctes de semi-conducteur, par exemple une couche 108 de semi-conducteur non dopé intentionnellement et formant une couche tampon disposée entre la couche 110 et le premier substrat 104, sur laquelle est disposée la couche 110 de semi-conducteur dopée n avec une concentration de donneurs par exemple comprise entre environ 10¹⁷ et 5.10²⁰ donneurs/cm³. L'épaisseur de la couche 108 est par exemple supérieure à environ 100 nm, par exemple égale à environ 3 µm, et celle de la couche 110 est par exemple comprise entre environ 100 nm et 3 µm.

Une ou plusieurs troisièmes couches 112 de semi-conducteur intrinsèque, c'est-à-dire non dopé intentionnellement (de concentration en donneurs résiduels n_{nid} par exemple égale à environ 10¹⁷ donneurs/cm³, ou comprise entre environ 10¹⁵ et 10¹⁸ donneurs/cm³), sont réalisées sur la première couche 106 (sur la couche 110 dans l'exemple représenté sur la figure 1A). Dans le premier mode de réalisation décrit ici, les troisièmes couches 112 correspondent à une zone active comprenant une ou plusieurs couches émissives, par exemple cinq, destinées à former chacune, dans les diodes 102, un puits quantique. Ces couches émissives comportent par exemple de l'InGaN. Chaque couche émissive est disposée entre deux couches barrières, comportant par exemple du GaN. L'épaisseur de la ou de chacune des couches émissives est par exemple égale à environ 3 nm et plus généralement comprise entre environ 0,5 nm et 10 nm, et l'épaisseur de chacune des couches barrières est par exemple comprise entre environ 1 nm et 25 nm.

Une deuxième couche 114 de semi-conducteur dopé selon un deuxième type de conductivité, opposé à celui du dopage de la première couche 106 et donc ici de type p, avec une concentration d'accepteurs par exemple comprise entre environ 10¹⁷ et 5.10¹⁹ accepteurs/cm³, est réalisée sur la ou les troisièmes couches 112. Les couches 106, 112 et 114 (et plus particulièrement les couches 110, 112 et 114 dans l'exemple décrit ici) sont destinées à former les jonctions p-i-n des diodes 102. Le semi-conducteur de la deuxième couche 114 est par exemple du GaN et son épaisseur est par exemple comprise entre environ 20 nm et 10 µm.

Dans une variante de réalisation, une couche de blocage d'électrons (non visible sur les figures 1A à 1J) peut être disposée entre la deuxième couche 114 et la ou les troisièmes couches 112, cette couche de blocage d'électrons comportant par exemple de l'AIGaN avec 12% d'aluminium et pouvant être dopée p avec une concentration d'accepteurs par exemple égale à environ 1.10¹⁷ accepteurs/cm³.

Des matériaux autres que ceux cités ci-dessus peuvent être utilisés pour réaliser les couches 106, 112 et 114. Par exemple, le matériau des couches émissives formées par les troisièmes couches 112 est choisi en fonction du spectre d'émission souhaité des diodes 102.

Une couche électriquement conductrice 115 destinée à former, dans chaque diode 102, une première partie d'une deuxième électrode qui sera en contact avec le semi-conducteur de la deuxième couche 114, est disposée sur la deuxième couche 114. Le matériau électriquement conducteur utilisé est avantageusement optiquement réflecteur, et correspond par exemple à de l'aluminium ou de l'argent.

Une couche 116 destinée à former un masque de gravure est réalisée sur la couche 115. Le matériau de cette couche 116 est par exemple du SiO₂.

Les couches 106, 112, 114 et 115 forment ensemble un empilement 117 à partir duquel les diodes 102 vont être réalisées.

Comme représenté sur la figure 1B, des motifs sont réalisés par lithographie et gravure (en utilisant par exemple un plasma fluoré tel que du CHF₃ ou du SF₆) dans la couche 116 tels que les portions restantes de cette couche 116 forment un masque de gravure 118. La résine de photolithographie utilisée pour réaliser le masque de gravure 118 est ensuite retirée. Les ouvertures formées dans le masque de gravure 118 correspondent aux motifs de tranchées à graver dans les couches de l'empilement 117 afin de définir les structures mesa des diodes 102.

Une gravure de tranchées 120 traversant la couche électriquement conductrice 115, la deuxième couche 114, la ou les troisièmes couches 112 et une première partie 122 de la première couche 106 est mise en oeuvre selon le motif du masque de gravure 118. Cette gravure est stoppée à un niveau de profondeur situé dans la première couche 106 telle qu'une deuxième partie 123 de la première couche 106 soit conservée au fond de chacune des tranchées 120 gravées. Sur la figure 1B, la première partie 122 de la première couche 106 est délimitée symboliquement de la deuxième partie 123 de la première couche 106 par un trait pointillé. Sur l'exemple décrit ici, la gravure est stoppée à un niveau se situant dans la couche 110 telle que la couche 108 et une partie de l'épaisseur de la couche 110 ne soient pas gravées. L'épaisseur de la première couche 106 qui est gravée, c'est-à-dire l'épaisseur de la première partie 122 de la première couche 106, est par exemple comprise entre environ 100 nm et 5 µm.

A l'issue de cette gravure, les tranchées 120 entourent :
- le masque de gravure 118 ;
- des portions restantes 124 de la couche électriquement conductrice 115 destinées à former des premières parties des deuxièmes électrodes des diodes 102,
- des portions restantes 126 de la deuxième couche 114 destinées à faire partie des jonctions p-n des diodes 102,
- des portions restantes 128 de la ou des troisièmes couches 112 destinées à former les zones actives de chaque diode 102, et
- des portions restantes 130 de la première partie 122 de la première couche 106 destinées à former, avec les portions restantes 126 de la deuxième couche 114, les jonctions p-n des diodes 102.

Les couches 115, 112, 114 et 106 sont gravées par voie sèche, par exemple par une gravure ionique réactive mise en oeuvre avec un système de torche à plasma, ou ICP-RIE pour « Inductively Coupled Plasma - Reactive Ion Etching ».

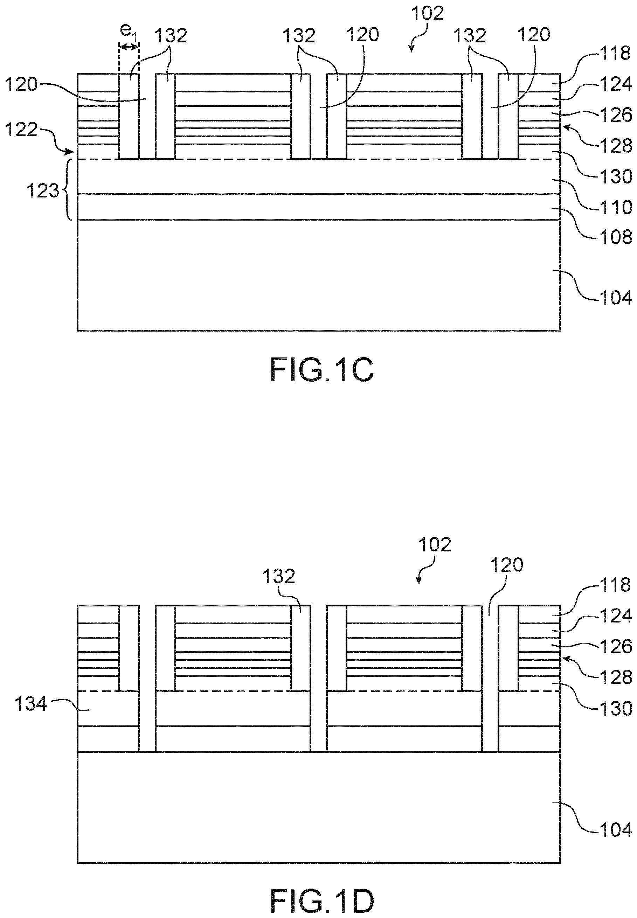

Un espaceur diélectrique 132 est ensuite réalisé dans les tranchées 120 (voir figure 1C). Pour cela, une couche diélectrique est déposée de manière conforme, par exemple par un dépôt de type PECVD (dépôt chimique en phase vapeur assisté par plasma), sur le masque de gravure 118 et contre les parois latérales et les parois de fond (i.e. le fond) des tranchées 120. Les parties de cette couche diélectrique qui ne recouvrent pas les parois latérales des tranchées 120, c'est-à-dire celles localisées sur le masque de gravure 118 et celles se trouvant au fond des tranchées 120, sont supprimées par une gravure anisotrope, correspondant par exemple une gravure sèche telle qu'une gravure RIE ou gravure ionique réactive. Les portions restantes de cette couche diélectrique forment l'espaceur diélectrique 132 qui recouvre les parois latérales des portions restantes 124, 126, 128 et 130 et celles du masque de gravure 118.

L'espaceur diélectrique 132 a une épaisseur initiale égale à celle de la couche diélectrique déposée. Cette épaisseur est importante et par exemple supérieure ou égale à environ 1 µm.Sur la figure 1C, cette épaisseur initiale porte la référence « e1 ». L'épaisseur de l'espaceur diélectrique 132 correspond à la dimension perpendiculaire à la surface contre laquelle le matériau de l'espaceur diélectrique 132 est déposé.

Comme représenté sur la figure 1D, une deuxième gravure de la couche 106 est ensuite mise en oeuvre, prolongeant les tranchées 120 jusqu'au premier substrat 104, à travers des portions de la deuxième partie 123 de la première couche 106 qui ne sont pas recouvertes par l'espaceur diélectrique 132. A l'issue de cette deuxième gravure, les tranchées 120 entourent également des portions restantes 134 de la deuxième partie 123 de la première couche 106.

Le masque de gravure 118, les portions restantes 124, 126, 128, 130, 134 et l'espaceur diélectrique 132 forment des structures mesa, c'est-à-dire des empilements sous forme d'îlots, disposées sur le premier substrat 104. Chaque structure mesa de chaque diode 102 a une section, dans un plan parallèle à la face du premier substrat 104 sur laquelle reposent ces structures, par exemple de forme rectangulaire. Chacune des structures mesa peut donc former un îlot de forme parallélépipédique. Des structures mesa de forme différente sont possibles, par exemple cylindriques.

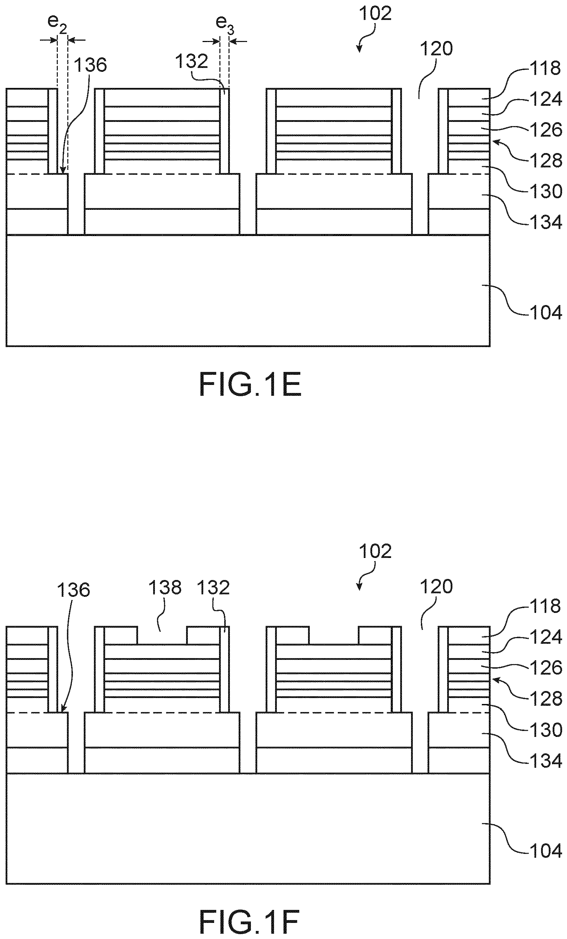

Une gravure latérale d'une partie de l'espaceur diélectrique 132 est ensuite mise en oeuvre, révélant des surfaces de contact 136 de la deuxième partie 123 de la première couche 106 (voir figure 1E). Les surfaces de contact 136 de la deuxième partie 123 de la première couche 106 révélées sont de préférence sensiblement horizontales, selon le sens d'orientation des figures. La gravure latérale permet donc de révéler des plans cristallins parallèles à la surface de croissance ayant de meilleures propriétés électriques que les plans perpendiculaires à la surface de croissance. La partie de l'espaceur diélectrique 132 qui est supprimée lors de cette gravure latérale a une épaisseur (référencée « e2 » sur la figure 1E) par exemple comprise entre environ 10 nm et l'épaisseur initiale de l'espaceur (e1) moins environ 10 nm, afin que l'épaisseur restante d'espaceur (référencée « e3 ») soit suffisante pour assurer une bonne isolation électrique. L'épaisseur e2 est par exemple égale à environ 600 nm lorsque l'espaceur diélectrique 132 a une épaisseur initiale e1 égale à environ 1 µm. La partie restante de l'espaceur diélectrique 132 a donc une épaisseur e3 = e1 - e2, et par exemple égale à 400 nm pour l'exemple précédemment décrit.

Dans ce premier mode de réalisation, la gravure latérale de l'espaceur diélectrique 132 mise en oeuvre correspond à une gravure isotrope, par exemple une gravure chimique par voie humide ou une gravure plasma isotrope. Lors d'une telle gravure isotrope, le masque de gravure 118 est donc également au moins partiellement gravé si le matériau du masque de gravure 118 est sensible aux agents de gravure utilisés (c'est le cas dans l'exemple de réalisation décrit ici où le masque de gravure 118 et l'espaceur diélectrique 132 comportent du SiO₂).

Des ouvertures 138 sont ensuite réalisées à travers le masque de gravure 118, formant des emplacements pour la réalisation de deuxièmes parties des deuxièmes électrodes des diodes 102 (figure 1F). Ces ouvertures 138 traversent toute l'épaisseur du masque de gravure 118 afin que les parois de fond (i.e. le fond) des ouvertures 138 soient formées par les portions 124. Cette gravure est par exemple de type ICP-RIE.

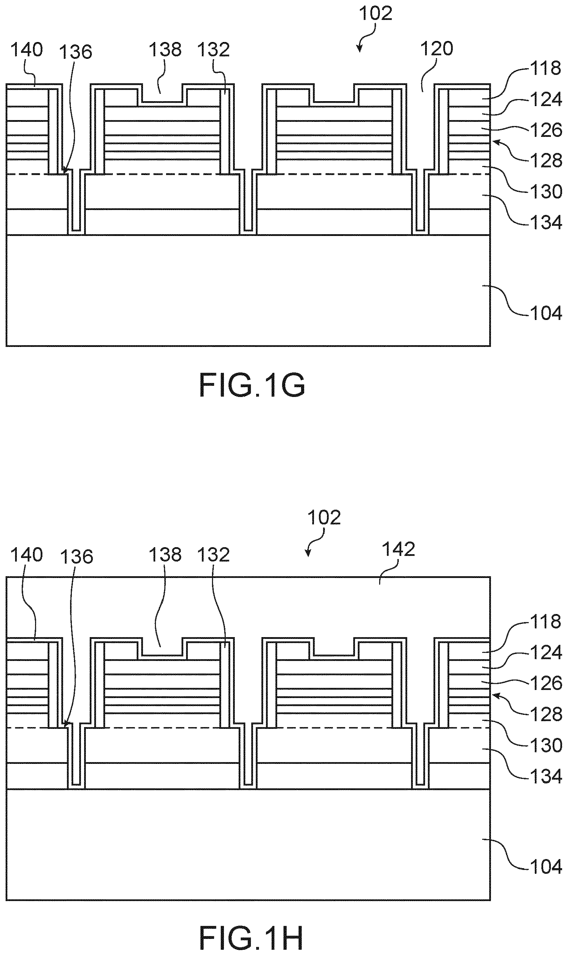

Un premier matériau électriquement conducteur 140 est ensuite déposé dans les tranchées 120, ainsi que sur les faces supérieures du masque de gravure 118 et dans les ouvertures 138 (figure 1G). Ce premier matériau électriquement conducteur 140 est déposé de manière conforme, c'est-à-dire en formant une couche d'épaisseur sensiblement constante sur le masque de gravure 118 et le long des parois des tranchées 120 et des ouvertures 138. Dans l'exemple de réalisation décrit ici, le premier matériau électriquement conducteur 140 est formé par le dépôt d'une première couche de titane d'épaisseur par exemple comprise entre environ 5 nm et 300 nm, suivi d'un dépôt d'une deuxième couche d'aluminium d'épaisseur par exemple comprise entre environ 50 nm et 1 µm. Dans une variante de réalisation, le premier matériau électriquement conducteur 140 est formé par une unique couche d'aluminium d'épaisseur par exemple comprise entre environ 50 nm et 1 µm.

Le premier matériau électriquement conducteur 140 déposé est en contact électriquement avec les flancs latéraux des portions 134 mais également avec les surfaces de contact 136 qui participent activement au contact électrique avec le semi-conducteur de la première couche 106 en complément de celui avec les flancs latéraux des portions 134. Le matériau électriquement conducteur 140 est également en contact avec les portions 124 au niveau des parois de fond (i.e. du fond) des ouvertures 138. Ces contacts électriques sont destinés à former les liaisons électriques entre les jonctions p-n et les anodes et cathodes des diodes 102.

Comme représenté sur la figure 1H, un deuxième matériau électriquement conducteur 142 est déposé en remplissant le volume restant des tranchées 120 et des ouvertures 138. Sur la figure 1H, l'épaisseur de ce deuxième matériau électriquement conducteur 142 est telle qu'il recouvre également les parties du premier matériau électriquement conducteur 140 disposées sur le masque de gravure 118. Le deuxième matériau électriquement conducteur 142 est par exemple du cuivre qui peut être formé par la mise en oeuvre d'un dépôt électrochimique (ECD ou « Electro-Chemical Déposition ») pleine plaque, c'est-à-dire sur l'ensemble de la structure précédemment réalisée.

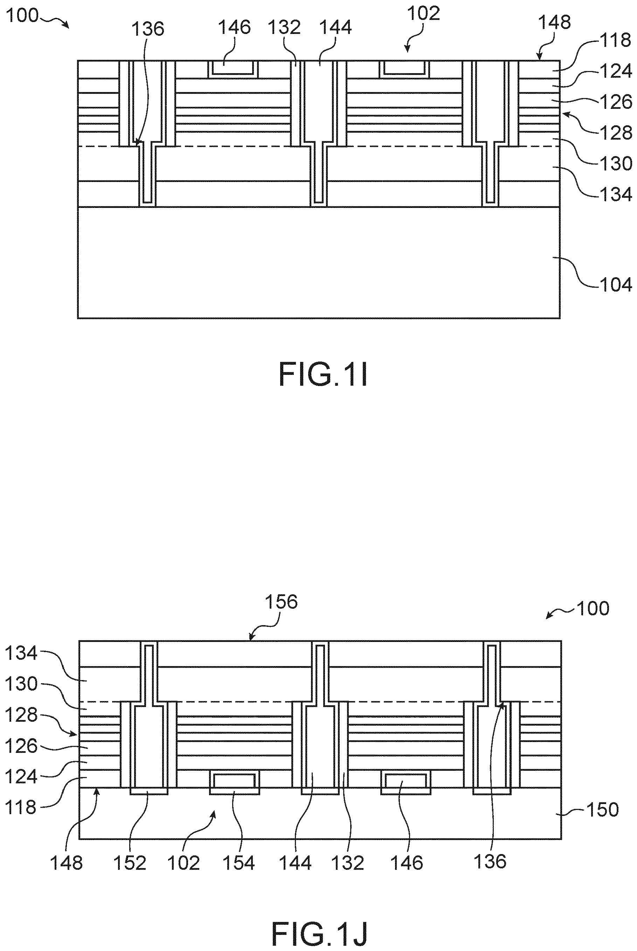

Enfin, les diodes 102 du dispositif 100 sont achevées en mettant en oeuvre une planarisation mécano-chimique (CMP) supprimant les portions des premier et deuxième matériaux électriquement conducteurs 140 et 142 qui dépassent des tranchées 120 et des ouvertures 138 et qui sont disposées sur le masque de gravure 118. Cette planarisation permet d'isoler électriquement les portions de matériaux conducteurs disposées dans les tranchées 120 vis-à-vis de celles disposées dans les ouvertures 138 (figure 1I). Les portions des matériaux électriquement conducteurs 140 et 142 disposées dans les tranchées 120 forment des premières électrodes 144 (correspondant à des cathodes dans l'exemple de réalisation décrit ici) s'étendant sur toute la hauteur des structures mesa des diodes 102 et qui sont reliées électriquement aux portions 134 de semi-conducteur. Les portions des matériaux électriquement conducteurs 140 et 142 disposées dans les ouvertures 138 forment des deuxièmes parties des deuxièmes électrodes 146 (correspondant à des anodes dans l'exemple décrit ici) reliées électriquement aux portions 124 correspondant aux premières parties des deuxièmes électrodes 146. Les deuxièmes électrodes 146 sont reliées aux portions 126 au niveau des faces supérieures de ces portions 126.

Cette planarisation forme également une face 148 du dispositif 100 qui est sensiblement plane et formée par les faces supérieures des électrodes 144, 146, de l'espaceur diélectrique 132 et du masque de gravure 118. Cette face 148 forme les faces arrière des diodes 102 au niveau desquelles des connexions électriques avec les électrodes 144, 146 seront réalisées.

Grâce à l'espaceur diélectrique 132, les premières électrodes 144 sont bien isolées électriquement des portions de semi-conducteur 124, des deuxièmes électrodes 146 et des portions 128 formant les zones actives des diodes 102.

Afin de garantir une isolation électrique entre les électrodes 144, 146 des diodes 102, et éviter la présence de parties des matériaux électriquement conducteurs 140 et 142 reliant électriquement une ou plusieurs des premières électrodes 144 avec une ou plusieurs des deuxièmes électrodes 146, l'étape de planarisation peut être avantageusement mise en oeuvre jusqu'à réaliser une sur-gravure des portions des matériaux électriquement conducteurs 140 et 142 disposés dans les tranchées 120 et dans les ouvertures 138 par rapport aux matériaux diélectriques de l'espaceur diélectrique 132 et du masque de gravure 118, formant dans les électrodes 144, 146 des creux au niveau des faces supérieures de ces électrodes. Ces creux peuvent avoir une profondeur, par rapport au plan de la face supérieure 148, comprise entre environ 5 nm et 150 nm. Cette sur-gravure peut être obtenue en jouant sur la sélectivité de gravure qui existe entre les matériaux diélectriques de l'espaceur 132 et du masque de gravure 118 et les matériaux électriquement conducteurs 140 et 142. La CMP mise en oeuvre présente une vitesse d'abrasion différente en fonction des matériaux, et dans le procédé décrit ici, l'abrasion des matériaux électriquement conducteurs 140 et 142 est plus rapide que celle des matériaux diélectriques de l'espaceur 132 et du masque de gravure 118. Cela se traduit, au niveau de la face supérieure 148 du dispositif 100, par un retrait des matériaux 140 et 142 par rapport à l'espaceur diélectrique 132 et au masque de gravure 118. Ainsi, les électrodes 144, 146 des diodes 102 restent parfaitement isolées les unes des autres grâce à une propriété intrinsèque de la planarisation mise en oeuvre. Une telle sur-gravure peut également être mise en oeuvre par un procédé de gravure RIE.

La surface sensiblement plane obtenue au niveau de la face supérieure 148 du dispositif 100 permet d'hybrider aisément la matrice de diodes 102 réalisée à tout type d'élément de connexion tel qu'un circuit électronique, et permet notamment de réaliser une telle hybridation par collage direct (« direct bonding », également appelé collage par adhésion moléculaire) de la matrice de diodes 102 au circuit électronique sans faire appel à des inserts, tels que des microbilles, entre la matrice de diodes 102 et le circuit électronique. Les collages directs de type métal-métal et diélectrique-diélectrique réalisés dans ce cas ont l'avantage d'être étanches. Le fait que des creux soient présents au niveau des faces supérieures des électrodes 144, 146 ne pose pas de problème pour la mise en oeuvre d'un tel collage direct car lors de ce collage direct, les matériaux de ces portions se dilatent et il est donc possible d'obtenir un très bon contact entre ces électrodes et des éléments conducteurs du circuit électronique. Des détails de mise en oeuvre d'un tel collage direct sont par exemple décrits dans le document « Mechanisms of copper direct bonding observed by in-situ and quantitative transmission electron microscope » de M. Martinez et al., Thin Solid Films vol. 530 (2013), pp. 96-99.

Comme représenté sur la figure 1J, la matrice de diodes 102 est reportée, au niveau de sa face supérieure 148, sur un substrat d'interconnexions 150 comportant des contacts électriques 152 et 154 auxquels les électrodes 144, 146 peuvent être reliées électriquement, par exemple via un collage direct comme décrit ci-dessus. Ce substrat d'interconnexions 150 peut correspondre à un circuit électronique sur lequel la matrice de diodes 102 est reportée.

Le procédé présenté et la surface sensiblement plane obtenue au niveau de la face supérieure 148 du dispositif 100 est également compatible avec les procédés d'hybridation classiques faisant appels par exemple à des inserts, tels que des microbilles ou des microtubes pour hybrider la matrice de diodes 102.

Après ce report, le premier substrat 104 peut être retiré, libérant ainsi une face avant 156 des diodes 102 par laquelle la lumière est destinée à entrer ou sortir (sortir dans l'exemple décrit ici où les diodes 102 correspondent à des LEDs). Le type de retrait mis en oeuvre dépend notamment de la nature du premier substrat 104. Par exemple, dans le cas d'un premier substrat 104 de saphir, celui-ci peut être retiré par décollement (« lift-off » en anglais). Il est également possible que le premier substrat 104 soit retiré par meulage (« grinding » en anglais), ou encore par gravure sélective.

Afin d'illustrer la gravure latérale mise en oeuvre au cours du procédé précédemment décrit, les figures 2A et 2B représentent des images obtenues par microscopie électronique lors d'une telle gravure latérale.

La figure 2A représente des structures mesa de semi-conducteur 10 de géométrie similaire à celles formées par les portions 124, 126, 128, 130 et 134 et le masque de gravure 118 après avoir gravé les tranchées 120. La figure 2B représente la surface de contact 136 obtenue par le retrait latéral partiel du masque de gravure 118 après avoir mis en oeuvre une gravure latérale isotrope, ici par voie chimique.

On décrit ci-dessous les étapes d'un procédé de réalisation d'un dispositif électronique 100 selon un deuxième mode de réalisation. Dans le deuxième mode de réalisation décrit ici, le dispositif 100 comporte plusieurs diodes 102 correspondant, dans ce deuxième mode de réalisation, à des diodes électroluminescentes.

Les étapes précédemment décrites en lien avec les figures 1A et 1B sont tout d'abord mises en oeuvre.

L'espaceur diélectrique 132 est ensuite réalisé dans les tranchées 120. Contrairement au premier mode de réalisation dans lequel l'espaceur diélectrique 132 est réalisé en déposant une seule couche épaisse de matériau diélectrique, l'espaceur diélectrique 132 est ici réalisé en déposant de manière conforme une couche 133 d'un premier matériau diélectrique, cette couche 133 recouvrant notamment, dans les tranchées 120, les parois latérales des portions 124, 126, 128 et 130 et du masque de gravure 118. Une couche 135 d'un deuxième matériau diélectrique est ensuite déposée en recouvrant la couche 133. Les premier et deuxième matériaux diélectriques sont choisis tels que le deuxième matériau diélectrique ait une vitesse de gravure supérieure à celle du premier matériau diélectrique lors de la gravure latérale d'une partie de l'espaceur diélectrique qui est ensuite mise en oeuvre, c'est-à-dire la gravure anisotrope des espaceurs et la gravure des couches de semi-conducteur. Par exemple, le premier matériau diélectrique de la couche 133 peut correspondre à du SiO₂ et le deuxième matériau diélectrique de la couche 135 peut correspondre à du SiN.

Les portions des couches 133 et 135 qui ne recouvrent pas les parois latérales des tranchées 120, c'est-à-dire celles localisées sur le masque de gravure 118 et celles se trouvant au fond des tranchées 120, sont supprimées par une gravure anisotrope, par exemple une gravure sèche telle qu'une gravure RIE. Les portions restantes de ces couches diélectriques 133 et 135 forment l'espaceur diélectrique 132 qui recouvre les parois latérales des portions restantes 124, 126, 128 et 130 et du masque de gravure 118 (voir figure 3A). La différence de vitesse de gravure entre le premier et le deuxième matériau diélectrique lors de cette gravure anisotrope résulte en une différence de hauteur entre la couche 135 et la couche 133 après la fabrication de l'espaceur diélectrique : la portion restante de la couche 135 est moins importante que la portion restante de la couche 133.

Une étape de gravure sélective peut ensuite être mise en oeuvre afin de supprimer une partie des portions restantes de la couche 135. La structure obtenue dans ce cas est représentée sur la figure 3B.

Une autre gravure est ensuite mise en oeuvre pour prolonger les tranchées 120 jusqu'au premier substrat 104, à travers des portions de la deuxième partie 123 de la première couche 106 qui ne sont pas recouvertes par l'espaceur diélectrique 132, c'est-à-dire non recouvertes par les portions des couches 133 et 135. A l'issue de cette deuxième gravure, les tranchées 120 entourent également des portions restantes 134 de la deuxième partie 123 de la première couche 106.

La mise en oeuvre de cette gravure supprime également les portions restantes de la couche 135. A l'issue de cette gravure, l'espaceur diélectrique 132 n'est alors formé plus que des portions restantes de la couche 133. Les surfaces libérées par la suppression des portions de la couche 135 forment les surfaces de contact 136 destinées aux contacts électriques avec le semi-conducteur des portions 134. La structure obtenue est donc similaire à celle représentée sur la figure 1E.

Avant la mise en oeuvre de cette gravure prolongeant les tranchées, la hauteur des portions de la couche 135 conservées est adaptée en fonction notamment de l'épaisseur du masque de gravure 118, des épaisseurs des différentes couches gravées de semi-conducteur, ou encore de la sélectivité de gravure des différents matériaux, et cela dans le but que tout au long de la gravure prolongeant les tranchées, les surfaces de contact 136 soient bien protégées par les portions de la couche 135 et qu'à la fin de cette gravure, les portions de la couche 135 soient bien supprimées.

Dans une variante de réalisation, il peut rester une partie de la portion restante de la couche 135 après la gravure prolongeant les tranchées qu'il convient alors de retirer à l'aide d'une gravure anisotrope sélective par rapport au matériau de la couche 133.

Les diodes 102 et le dispositif 100 sont ensuite achevés comme dans le premier mode de réalisation, en mettant en oeuvre les différentes étapes précédemment décrites en lien avec les figures 1F à 1J.

Dans les premier et deuxième modes de réalisation particuliers décrits ci-dessus, les portions de semi-conducteur 130, 134 sont de type n et les deuxièmes portions de semi-conducteur 126 sont de type p. En variante, les portions de semi-conducteur 130, 134 peuvent être de type p et les deuxièmes portions de semi-conducteur 126 peuvent être de type n, avec dans ce cas les portions de matériau électriquement conducteur disposées dans les tranchées 120 formant les anodes des diodes 102 et les portions de matériaux électriquement conducteurs disposées dans les ouvertures 138 formant, avec les portions 124, les cathodes des diodes 102.

En outre, dans les premier et deuxième modes de réalisation décrits ici, les précédentes étapes mises en oeuvre sont telles que les surfaces de contact 136 sont sensiblement perpendiculaires aux parois latérales des portions restantes 124, 126, 128, 130 et 134. En variante, suivant la géométrie souhaitée pour les diodes 102 et donc des gravures mises en oeuvre, il est possible que les surfaces de contact 136 ne soient pas perpendiculaires à ces parois latérales.

De plus, dans les premier et deuxième modes de réalisation décrits précédemment, le dispositif 100 comporte une matrice de diodes 102 qui sont des diodes électroluminescentes, le dispositif microélectronique 100 pouvant faire partie d'un dispositif d'affichage à LEDs (écrans, projecteur, mur d'images, etc.). Cette matrice de diodes 102 comporte les premières électrodes 144 qui forment une même électrode commune à toutes les diodes 102, et chaque diode 102 comporte une deuxième électrode 146 permettant de réaliser l'adressage individuel de chacune des diodes 102.

En variante, le dispositif microélectronique 100 peut comporter une matrice de diodes 102 qui sont des diodes photo-réceptrices, ou photodiodes. Dans cette variante, les électrodes 144, 146 ne servent pas à fournir du courant aux diodes 102 mais servent à récupérer les courants photo-générés par les diodes 102.

En variante, le dispositif 100 peut comporter, sur la face supérieure 148, une structure de connexion différente du substrat d'interconnexion 150, formant les connexions électriques des diodes 102 et comportant des premiers éléments électriquement conducteurs reliés électriquement aux premières électrodes 144 des diodes 102 et des deuxièmes éléments électriquement conducteurs reliés électriquement aux deuxièmes électrodes 146 des diodes 102. Ces éléments électriquement conducteurs d'une telle structure de connexion sont isolés électriquement les uns des autres par des éléments diélectriques dont les dimensions, dans le plan de la face 148, sont au moins égales à celles de l'espaceur diélectrique 132 et du masque de gravure 118 afin que les éléments électriquement conducteurs ne forment pas de court-circuit entre les électrodes des diodes 102.

Dans les modes de réalisation précédemment décrits, les diodes 102 réalisées forment une matrice de diodes servant de matrice de pixels du dispositif 100. En variante, les diodes 102 peuvent être réalisées les unes à côté des autres sans former une matrice de diodes et/ou sans espacements réguliers entre elles.

L'étendue de la présente invention est définie par les revendications qui suivent, à l'aune de la description et des dessins qui précèdent.

## Revendications

1. Procédé de réalisation d'au moins une diode (102) photo-émettrice ou photo-réceptrice, comportant au moins :
- réalisation, sur un premier substrat (104), d'au moins un empilement (117) comprenant des première et deuxième couches (106, 114) de semi-conducteur dopées selon des types de conductivité opposés, et au moins une troisième couche (112) de semi-conducteur intrinsèque disposée entre les première et deuxième couches (106, 114), la première couche (106) étant disposée entre le premier substrat (104) et la troisième couche (112) ;
- gravure de tranchées (120) traversant les deuxième et troisième couches (114, 112) et une première partie (122) de la première couche (106), entourant des portions restantes (126, 128, 130) des deuxième et troisième couches (114, 112) et de la première partie (122) de la première couche (106), et telles que le fond des tranchées soit formé par une deuxième partie (123) de la première couche (106) disposée entre la première partie (122) de la première couche (106) et le premier substrat (104) ;
- réalisation, dans les tranchées (120), d'au moins un espaceur diélectrique (132) recouvrant des parois latérales desdites portions restantes (126, 128, 130) ;
- gravure prolongeant les tranchées (120) à travers des portions de la deuxième partie (123) de la première couche (106) non recouvertes par l'espaceur diélectrique (132), jusqu'au premier substrat (104) ;
- gravure latérale d'une partie de l'espaceur diélectrique (132), révélant des surfaces de contact (136) de la deuxième partie (123) de la première couche (106) ;
- réalisation, dans les tranchées (120), d'au moins une première électrode (144) en contact avec les surfaces de contact (136) de la deuxième partie (123) de la première couche (106) et avec des flancs latéraux de la deuxième partie (123) de la première couche (106).

2. Procédé selon la revendication 1, dans lequel l'espaceur diélectrique (132) a, avant la mise en oeuvre de la gravure latérale, une épaisseur initiale supérieure ou égale à 1 µm.

3. Procédé selon la revendication 1, dans lequel la partie de l'espaceur diélectrique (132) supprimée lors de la gravure latérale a une épaisseur (e₂) comprise entre 10 nm et une épaisseur initiale (e₁) de l'espaceur moins 10 nm.

4. Procédé selon l'une des revendications précédentes, dans lequel les surfaces de contact (136) de la deuxième partie (123) de la première couche (106) sont perpendiculaires aux parois latérales desdites portions restantes (126, 128, 130).

5. Procédé selon l'une des revendications précédentes, comportant en outre, entre la réalisation de l'empilement (117) et la gravure des tranchées (120) à travers les deuxième et troisième couches (106, 114) et la première partie (122) de la première couche (106), la réalisation d'au moins un masque de gravure (118) disposé sur l'empilement (117) et ayant un motif correspondant à celui des tranchées (120), et dans lequel l'espaceur diélectrique (132) est réalisé en recouvrant également des parois latérales du masque de gravure (118).

6. Procédé selon l'une des revendications précédentes, dans lequel la gravure latérale d'une partie de l'espaceur diélectrique (132) correspond à une gravure isotrope.

7. Procédé selon les revendications 5 et 6, dans lequel le masque de gravure (118) comporte au moins un matériau qui est au moins partiellement gravé lors de la gravure latérale d'une partie de l'espaceur diélectrique (132).

8. Procédé selon l'une des revendications 6 ou 7, dans lequel l'espaceur diélectrique (132) comporte du SiO₂.

9. Procédé selon l'une des revendications 1 à 5, dans lequel la réalisation de l'espaceur diélectrique (132) comporte :
- dépôt d'au moins une couche (133) d'un premier matériau diélectrique recouvrant les parois latérales desdites portions restantes (126, 128, 130) ;
- dépôt d'au moins une couche (135) d'un deuxième matériau diélectrique recouvrant la couche (133) du premier matériau diélectrique, le deuxième matériau diélectrique étant choisi tel qu'il ait une vitesse de gravure supérieure à celle du premier matériau diélectrique lors de la gravure latérale d'une partie de l'espaceur diélectrique (132) qui correspond à une gravure anisotrope ;
et dans lequel la gravure prolongeant les tranchées (120) et la gravure latérale d'une partie de l'espaceur diélectrique (132) sont mises en oeuvre simultanément au cours d'une même étape de gravure.

10. Procédé selon l'une des revendications précédentes, dans lequel :
- l'empilement (117) comporte en outre au moins une couche électriquement conductrice (115) telle que la deuxième couche (114) soit disposée entre la troisième couche (112) et la couche électriquement conductrice (115) ;
- les tranchées (120) gravées traversent la couche électriquement conductrice (115) et entourent au moins une portion restante (124) de la couche électriquement conductrice (115) formant une première partie d'une deuxième électrode (146) ;
- l'espaceur diélectrique (132) recouvre des parois latérales de la première partie de la deuxième électrode (146) ;
et comportant en outre, après la gravure latérale d'une partie de l'espaceur diélectrique (132), une étape de réalisation d'une deuxième partie de la deuxième électrode (146).

11. Procédé selon la revendication 10, dans lequel la réalisation de la première électrode (144) et de la deuxième partie de la deuxième électrode (146) comporte au moins :
- réalisation d'au moins une ouverture (138) à travers l'empilement (117) et débouchant sur la première partie de la deuxième électrode (146) ;
- dépôt d'au moins un matériau électriquement conducteur (140, 142) dans l'ouverture (138) et dans les tranchées (120) ;
- planarisation du matériau électriquement conducteur (140, 142).

12. Procédé selon l'une des revendications 10 ou 11, comportant en outre, après la réalisation de la première électrode (144) et de la deuxième partie de la deuxième électrode (146), un report de la diode (102) photo-émettrice ou photo-réceptrice sur un substrat d'interconnexions (150) tel que les première et deuxième électrodes (144, 146) de la diode (102) photo-émettrice ou photo-réceptrice soient reliées électriquement au substrat d'interconnexions (150), puis une étape de retrait du premier substrat (104).

13. Procédé selon l'une des revendications 10 à 12, dans lequel la couche électriquement conductrice (115) est optiquement réflectrice.

14. Procédé de réalisation d'un dispositif électronique (100), comportant la mise en oeuvre du procédé selon l'une des revendications précédentes, dans lequel les étapes mises en oeuvre forment plusieurs diodes (102) photo-émettrices et/ou plusieurs diodes (102) photo-réceptrices dans lesquelles les premières électrodes (144) desdites diodes (102) sont reliées électriquement entre elles.

## Patentansprüche

1. Verfahren zur Herstellung von mindestens einer Photoemittier- oder Photorezeptordiode (102), mindestens beinhaltet:
- Herstellung, auf einem ersten Substrat (104), mindestens eines Stapels (117), der erste und zweite Halbleiterschichten (106, 114) umfasst, die gemäß entgegengesetzten Leitfähigkeitstypen dotiert sind, und mindestens eine dritte intrinsische Halbleiterschicht (112), die zwischen der ersten und zweiten Schicht (106, 114) angeordnet ist, wobei die erste Schicht (106) zwischen dem ersten Substrat (104) und der dritten Schicht (112) angeordnet ist;
- Ätzung von Schneisen (120), die durch die zweite und dritte Schicht (114, 112) und einen ersten Teil (122) der ersten Schicht (106) verlaufen und die verbleibenden Bereiche (126, 128, 130) der zweiten und dritten Schicht (114, 112) und den ersten Teil (122) der ersten Schicht (106) umgeben, und so dass der Boden der Schneisen durch einen zweiten Teil (123) der ersten Schicht (106) gebildet ist, der zwischen dem ersten Teil (122) der ersten Schicht (106) und dem ersten Substrat (104) angeordnet ist;
- Herstellung, in den Schneisen (120), mindestens eines dielektrischen Abstandshalters (132), der die Seitenwände der verbleibenden Bereiche (126, 128, 130) bedeckt;
- Ätzung, die die Schneisen (120) durch Bereiche des zweiten Teils (123) der ersten Schicht (106), die nicht vom dielektrischen Abstandshalter (132) bedeckt sind, bis zum ersten Substrat (104) verlängert;
- seitliche Ätzung eines Teils des dielektrischen Abstandshalters (132), wobei Kontaktflächen (136) des zweiten Teils (123) der ersten Schicht (106) aufgedeckt werden;
- Herstellung, in den Schneisen (120), mindestens einer ersten Elektrode (144) in Kontakt mit den Kontaktflächen (136) des zweiten Teils (123) der ersten Schicht (106) und mit Seitenflanken des zweiten Teils (123) der ersten Schicht (106).

2. Verfahren nach Anspruch 1, wobei der dielektrische Abstandshalter (132) vor der Ausführung der seitlichen Ätzung eine Anfangsdicke von größer oder gleich 1 µm aufweist.

3. Verfahren nach Anspruch 1, wobei der Teil des dielektrischen Abstandshalters (132), der bei der seitlichen Ätzung entfernt wird, eine Dicke (e₂) zwischen 10 nm und einer Anfangsdicke (e₁) des Abstandshalters von weniger als 10 nm aufweist.

4. Verfahren nach einem der vorhergehenden Ansprüche, wobei die Kontaktflächen (136) des zweiten Teils (123) der ersten Schicht (106) senkrecht zu den Seitenwänden der verbleibenden Bereiche (126, 128, 130) sind.

5. Verfahren nach einem der vorhergehenden Ansprüche, ferner beinhaltend, zwischen der Herstellung des Stapels (117) und der Ätzung der Schneisen (120), die durch die zweite und dritte Schicht (106, 114) und den ersten Teil (122) der ersten Schicht (106) verlaufen, die Herstellung von mindestens einer Ätzmaske (118), die auf dem Stapel (117) angeordnet ist und ein Muster aufweist, das dem der Schneisen (120) entspricht, und wobei bei der Herstellung des dielektrische Abstandshalters (132) auch die Seitenwände der Ätzmaske (118) bedeckt werden.

6. Verfahren nach einem der vorhergehenden Ansprüche, wobei die seitliche Ätzung eines Teils des dielektrischen Abstandshalters (132) einer isotropen Ätzung entspricht.

7. Verfahren nach Anspruch 5 und 6, wobei die Ätzmaske (118) mindestens ein Material beinhaltet, das bei der seitlichen Ätzung eines Teils des dielektrischen Abstandshalters (132) mindestens teilweise geätzt wird.

8. Verfahren nach einem der Ansprüche 6 oder 7, wobei der dielektrische Abstandshalter (132) SiO₂ beinhaltet.

9. Verfahren nach einem der Ansprüche 1 bis 5, wobei die Herstellung des dielektrischen Abstandshalters (132) beinhaltet:
- Abscheidung mindestens einer Schicht (133) eines ersten dielektrischen Materials, das die Seitenwände der verbleibenden Bereiche (126, 128, 130) bedeckt;
- Abscheidung mindestens einer Schicht (135) eines zweiten dielektrischen Materials, das die Schicht (133) des ersten dielektrischen Materials bedeckt, wobei das zweite dielektrische Material so ausgewählt wird, dass es bei der seitlichen Ätzung eines Teils des dielektrischen Abstandshalters (132), die einer anisotropen Ätzung entspricht, eine höhere Ätzgeschwindigkeit als das erste dielektrische Material aufweist;
und wobei die Ätzung, die die Schneisen (120) verlängert, und die seitliche Ätzung eines Teils des dielektrischen Abstandshalters (132) gleichzeitig in einem einzigen Ätzschritt ausgeführt werden.

10. Verfahren nach einem der vorhergehenden Ansprüche, wobei:
- der Stapel (117) ferner mindestens eine elektrisch leitende Schicht (115) beinhaltet, so dass die zweite Schicht (114) zwischen der dritten Schicht (112) und der elektrisch leitenden Schicht (115) angeordnet ist;
- die geätzten Schneisen (120), die durch die elektrisch leitende Schicht (115) verlaufen, und mindestens einen verbleibenden Bereich (124) der elektrisch leitenden Schicht (115) umgeben, einen ersten Teil einer zweiten Elektrode (146) bilden;
- der dielektrische Abstandshalter (132) die Seitenwände des ersten Teils der zweiten Elektrode (146) bedeckt;
und ferner beinhaltend, nach der seitlichen Ätzung eines Teils des dielektrischen Abstandshalters (132), einen Schritt zur Herstellung eines zweiten Teils der zweiten Elektrode (146).

11. Verfahren nach Anspruch 10, wobei die Herstellung der ersten Elektrode (144) und des zweiten Teils der zweiten Elektrode (146) mindestens beinhaltet:
- Herstellung mindestens einer Öffnung (138), die durch den Stapel (117) verläuft und in den ersten Teil der zweiten Elektrode (146) mündet;
- Abscheidung mindestens eines elektrisch leitenden Materials (140,142) in der Öffnung (138) und in den Schneisen (120);
- Planarisierung des elektrisch leitenden Materials (140, 142).

12. Verfahren nach einem der Ansprüche 10 oder 11, ferner beinhaltend, nach der Herstellung der ersten Elektrode (144) und des zweiten Teils der zweiten Elektrode (146), eine Übertragung der Photoemittier- oder Photorezeptordiode (102) auf ein Vernetzungssubstrat (150), so dass die erste und die zweite Elektrode (144, 146) der Photoemittier- oder Photorezeptordiode (102) elektrisch mit dem Vernetzungssubstrat (150) verbunden sind, und danach einen Schritt zur Entfernung des ersten Substrats (104).

13. Verfahren nach einem der Ansprüche 10 bis 12, wobei die elektrisch leitende Schicht (115) optisch reflektierend ist.

14. Verfahren zur Herstellung einer elektronischen Vorrichtung (100), die Ausführung des Verfahrens nach einem der vorhergehenden Ansprüche beinhaltend, wobei die ausgeführten Schritte mehrere Photoemittierdioden (102) und/oder mehrere Photorezeptordioden (102) bilden, wobei die ersten Elektroden (144) der Dioden (102) elektrisch miteinander verbunden sind.

## Claims

1. Method for producing at least one light-emitting or light-receiving diode (102), comprising at least:
- producing, on a first substrate (104), at least one stack (117) comprising first and second semiconductor layers (106, 114) doped with opposite conductivity types, and at least one third intrinsic semiconductor layer (112) disposed between the first and second layers (106, 114), the first layer (106) being disposed between the first substrate (104) and the third layer (112);
- etching trenches (120) passing through the second and third layers (114, 112) and a first part (122) of the first layer (106), surrounding remaining portions (126, 128, 130) of the second and third layers (114, 112) and of the first part (122) of the first layer (106), and such that the bottom of the trenches is formed by a second part (123) of the first layer (106) disposed between the first part (122) of the first layer (106) and the first substrate (104);
- producing, in the trenches (120), at least one dielectric spacer (132) covering side walls of said remaining portions (126, 128, 130);
- etching extending the trenches (120) through portions of the second part (123) of the first layer (106) not covered with the dielectric spacer (132), up to the first substrate (104);
- laterally etching a part of the dielectric spacer (132), revealing contact surfaces (136) of the second part (123) of the first layer (106);
- producing, in the trenches (120), at least one first electrode (144) in contact with the contact surfaces (136) of the second part (123) of the first layer (106) and with side flanks of the second part (123) of the first layer (106).

2. Method according to claim 1, wherein the dielectric spacer (132) has, prior implementing lateral etching, an initial thickness greater than or equal to 1 µm.

3. Method according to claim 1, wherein the part of the dielectric spacer (132) removed during lateral etching has a thickness (e₂) of between 10 nm and an initial thickness (e₁) of the spacer minus 10 nm.

4. Method according to one of the preceding claims, wherein the contact surfaces (136) of the second part (123) of the first layer (106) are perpendicular to the side walls of said remaining portions (126, 128, 130).

5. Method according to one of the preceding claims, further comprising, between producing the stack (117) and etching the trenches (120) through the second and third layers (106, 114) and the first part (122) of the first layer (106), producing at least one etch mask (118) disposed on the stack (117) and having a pattern corresponding to that of the trenches (120), and wherein the dielectric spacer (132) is made by also covering side walls of the etch mask (118).

6. Method according to one of the preceding claims, wherein laterally etching a part of the dielectric spacer (132) corresponds to isotropic etching.

7. Method according to claims 5 and 6, wherein the etch mask (118) comprises at least one material which is at least partially etched upon laterally etching a part of the dielectric spacer (132).

8. Method according to one of claims 6 or 7, wherein the dielectric spacer (132) comprises SiOz.

9. Method according to one of claims 1 to 5, wherein producing the dielectric spacer (132) comprises:
- depositing at least one layer (133) of a first dielectric material covering the side walls of said remaining portions (126, 128, 130);
- depositing at least one layer (135) of a second dielectric material covering the layer (133) of the first dielectric material, the second dielectric material being chosen such that it has an etching rate greater than that of the first dielectric material upon laterally etching a part of the dielectric spacer (132) which corresponds to anisotropic etching;
and wherein etching extending the trenches (120) and laterally etching a part of the dielectric spacer (132) are simultaneously implemented during a same etching step.

10. Method according to one of the preceding claims, wherein:
- the stack (117) further comprises at least one electrically conductive layer (115) such that the second layer (114) is disposed between the third layer (112) and the electrically conductive layer (115);
- the trenches (120) etched pass through the electrically conductive layer (115) and surround at least one remaining portion (124) of the electrically conductive layer (115) forming a first part of a second electrode (146);
- the dielectric spacer (132) covers side walls of the first part of the second electrode (146);
and further comprising, after laterally etching a part of the dielectric spacer (132), a step of producing a second part of the second electrode (146).

11. Method according to claim 10, wherein producing the first electrode (144) and the second part of the second electrode (146) comprises at least:
- producing at least one opening (138) through the stack (117) and emerging on the first part of the second electrode (146);
- depositing at least one electrically conductive material (140, 142) into the opening (138) and into the trenches (120);
- planarising the electrically conductive material (140, 142).

12. Method according to one of claims 10 or 11, further comprising, after producing the first electrode (144) and the second part of the second electrode (146), transferring the light-emitting or light-receiving diode (102) onto an interconnection substrate (150) such that the first and second electrodes (144, 146) of the light-emitting or light-receiving diode (102) are electrically connected to the interconnection substrate (150), and then a step of removing the first substrate (104).

13. Method according to one of claims 10 to 12, wherein the electrically conductive layer (115) is optically reflective.

14. Method for producing an electronic device (100), comprising implementing the method according to one of the preceding claims,
wherein the steps implemented form several light-emitting diodes (102) and/or several light-receiving diodes (102) in which the first electrodes (144) of said diodes (102) are electrically interconnected.
